# EUROPÄISCHE PATENTSCHRIFT

(11) **EP 2 414 887 B1**
(45) Veröffentlichungstag und Bekanntmachung des Hinweises auf die Patenterteilung: **06.12.2017**
(21) Anmeldenummer: 10712396.0
(22) Anmeldetag: 24.03.2010
(51) Int. Cl.: B82Y 20/00, H01L 27/32, H01L 51/00, H01L 51/50, H01L 51/52

(54) **VERFAHREN ZUR HERSTELLUNG EINES ORGANISCHEN OPTOELEKTRONISCHEN BAUTEILS**
METHOD FOR PRODUCING AN ORGANIC OPTOELECTRONIC COMPONENT
PROCÉDÉ DE FABRICATION D'UN COMPOSANT OPTOÉLECTRONIQUE ORGANIQUE

(30) Priorität: 30.03.2009 DE 102009015574; 27.05.2009 DE 102009022902
(43) Veröffentlichungstag der Anmeldung: 08.02.2012
(73) Patentinhaber: OSRAM OLED GmbH, 93049 Regensburg (DE)
(72) Erfinder: INGLE, Andrew, 85391 Allershausen (DE)
(74) Vertreter: Epping - Hermann - Fischer
(86) Internationale Anmeldenummer: PCT/EP2010/053844
(87) Internationale Veröffentlichungsnummer: WO 2010/112381

(56) Entgegenhaltungen:
- EP-A1- 1 684 550
- EP-A1- 1 835 513
- EP-A2- 1 071 145
- WO-A1-98/03043
- WO-A2-2007/096565
- GB-A- 2 419 023
- JP-A- 2006 294 261
- US-A1- 2002 175 620
- US-A1- 2004 082 250

## Beschreibung

Es wird ein Verfahren zur Herstellung eines organischen optoelektronischen Bauteils angegeben.

Die Druckschrift GB 2 419 023 A betrifft ein Display.

In der Druckschrift EP 1 071 145 A2 sind ein Display sowie eine Herstellungsmethode hierfür offenbart.

Ein Herstellungsverfahren für ein organisches Display findet sich in der Druckschrift JP 2006-294261 A. Hierin wird die Austrittsarbeit einer metallischen Anode eines organischen elektrolumineszierenden Elements des organischen Displays durch eine UV-Ozon-Behandlung erhöht zur Bildung eines organischen Displays hoher Helligkeit. Die Beschreibung eines elektronischen Bauteils sowie einer entsprechenden Herstellungsmethode dafür sind in der Druckschrift EP 1 835 513 A1 zu finden.

Die Druckschrift EP 1 684 550 A1 offenbart ein organisches elektrolumineszierendes Element mit lichtemittierenden und nichtlichtemittierenden Bereichen, wobei die Austrittsarbeit einer indiumzinnoxidischen Anode lokal durch eine UV-Behandlung zur Bildung der lichtemittierenden Bereiche erhöht wird. Eine zu lösende Aufgabe besteht darin, ein Verfahren zur Herstellung eines organischen optoelektronischen Bauteils anzugeben, das Hellbereiche und Dunkelbereiche aufweist, die außerhalb des Betriebs des organischen optoelektronischen Bauteils nicht äußerlich unterscheidbar sind.

Diese Aufgabe wird durch ein Verfahren mit den Merkmalen des Anspruchs 1 gelöst.

In einer nicht zur Erfindung gehörenden Abwandlung der Erfindung wird außerdem ein organisches optoelektronisches Bauteil angegeben, welches im Nachfolgenden auch als organisches Bauteil oder als Bauteil angedeutet wird. Gemäß zumindest einer Ausbildung des organischen optoelektronischen Bauteils weist dieses einen Träger auf. Der Träger dient dazu, das Bauteil mechanisch zu stützen. Über den Träger kann das Bauteil also mechanisch stabilisiert sein. Der Träger kann eines der folgenden Materialien umfassen oder aus einem der folgenden Materialien bestehen: Glas, Glasfolie, Quarz, Kunststoff, Kunststofffolie, Metall, Metallfolie, Silizium. Bevorzugt ist das Substrat vollständig oder stellenweise transparent oder transluzent für eine vom Bauteil zu emittierende elektromagnetische Strahlung.

Gemäß zumindest einer Ausbildung des Bauteils ist an dem Träger eine erste Elektrode angebracht. Die erste Elektrode kann in direktem, unmittelbarem Kontakt zum Träger stehen. Ebenso ist es möglich, dass zwischen dem Träger und der ersten Elektrode stellenweise oder ganzflächig wenigstens eine Zwischenschicht angebracht ist. Über die Zwischenschicht kann eine Oberflächeneigenschaft des Trägers an die erste Elektrode angepasst sein. Beispielsweise dient die Zwischenschicht zu einer Haftvermittlung zwischen dem Träger und der ersten Elektrode. Auch kann über die Zwischenschicht eine Rauheit einer Oberfläche des Trägers vermindert sein. Ist eine Zwischenschicht vorhanden, so ist diese bevorzugt transparent oder transluzent bezüglich der vom Bauteil zu emittierenden Strahlung gestaltet.

Gemäß zumindest einer Ausbildung des Bauteils ist die erste Elektrode strahlungsdurchlässig, bevorzugt transparent für die vom Bauteil zu emittierende Strahlung gestaltet. Zum Beispiel ist die erste Elektrode als Anode ausgeführt. Die erste Elektrode dient dann als Löcher-Injizierendes Material. Die erste Elektrode besteht beispielsweise aus einem transparenten leitfähigen Oxid. Geeignete Materialien sind unter anderem Zinkoxid, Zinnoxid, Cadmiumoxid, Titanoxid, Indiumoxid, Indiumzinkoxid oder Indiumzinnoxid. Das Material der ersten Elektrode kann Dotierstoffe aufweisen und zumindest stellenweise p-dotiert oder n-dotiert sein.

Gemäß zumindest einer Ausbildung des Bauteils ist an einer dem Träger abgewandten Hauptseite der ersten Elektrode eine organische Schichtenfolge aufgebracht. Die organische Schichtenfolge umfasst mindestens eine organische aktive Schicht. Die aktive Schicht ist dazu ausgestaltet, im Betrieb des Bauteils die zu emittierende elektromagnetische Strahlung zu erzeugen. Eine Wellenlänge der Strahlung liegt im Spektralbereich zwischen 200 nm und 3000 nm, bevorzugt zwischen 350 nm und 850 nm. Insbesondere wird im Betrieb in der aktiven Schicht sichtbare Strahlung erzeugt.

Gemäß zumindest einer Ausbildung des Bauteils weist die organische Schichtenfolge neben der mindestens einen organischen aktiven Schicht zumindest eine Ladungsträgertransportschicht und/oder eine Ladungsträgerinjektionsschicht und/oder eine Ladungsträgerstoppschicht auf.

Gemäß zumindest einer Ausbildung des Bauteils umfasst die organische aktive Schicht zumindest ein organisches Polymer, ein organisches Oligomer, ein organisches Monomer, organische kleine nicht-polymere Moleküle oder eine Kombination hieraus.

Gemäß zumindest einer Ausbildung des Bauteils ist an einer dem Träger abgewandten Seite der organischen Schichtenfolge eine zweite Elektrode aufgebracht. Die organische Schichtenfolge befindet sich also zwischen der ersten Elektrode und der zweiten Elektrode. Zum Beispiel ist die zweite Elektrode als Kathode ausgeführt. Insbesondere umfasst die zweite Elektrode eines der folgenden Materialien oder besteht aus einem solchen Material: Aluminium, Barium, Indium, Silber, Gold, Magnesium, Kalzium, Lithium, Stahl. Bevorzugt ist die zweite Elektrode undurchlässig und/oder reflektierend für die in der organischen Schichtenfolge erzeugte Strahlung ausgestaltet. Es ist möglich, dass die zweite Elektrode, neben dem Träger, das Bauteil mechanisch stabilisiert.

Gemäß zumindest einer Ausbildung des Bauteils weist dieses eine Strahlungsdurchtrittsfläche auf. Die Strahlungsdurchtrittsfläche kann eine Begrenzungsfläche des Bauteils sein, durch das die in der aktiven Schicht erzeugte Strahlung oder ein Teil oder ein Großteil dieser Strahlung das Bauteil verlässt. Beispielsweise ist die Strahlungsdurchtrittsfläche durch eine der organischen Schichtenfolge abgewandte Hauptseite des Trägers gebildet. Die Strahlungsdurchtrittsfläche kann auch durch eine beispielsweise antireflektierend wirkende Beschichtung auf dieser Hauptseite des Trägers realisiert sein.

Gemäß zumindest einer Ausbildung des organischen Bauteils sind in einer lateralen Richtung mindestens ein Dunkelbereich und mindestens ein Hellbereich ausgebildet. Lateral bedeutet insbesondere entlang zumindest einer Haupterstreckungsrichtung des organischen Bauteils. Der Hellbereich ist hierbei ein Bereich der Strahlungsdurchtrittsfläche des Bauteils, in dem pro Flächeneinheit eine größere Strahlungsleistung emittiert wird als in dem Dunkelbereich. Insbesondere in Draufsicht auf das Bauteil erscheint also im Betrieb des Bauteils der Hellbereich heller als der Dunkelbereich. Bevorzugt weist das Bauteil mehrere Hellbereiche und mehrere Dunkelbereich auf. Die Hellbereiche und die Dunkelbereiche sind hierbei jeweils zusammenhängende Gebiete der Strahlungsdurchtrittsfläche des Bauteils.

Gemäß zumindest einer Ausbildung des Bauteils sind sowohl in dem mindestens einen Dunkelbereich als auch in dem mindestens einen Hellbereich vollständig oder stellenweise die erste und die zweite Elektrode sowie die organische Schichtenfolge an dem Träger aufgebracht. Mit anderen Worten weisen dann sowohl der Hellbereich als auch der Dunkelbereich bezüglich der Elektroden und der organischen Schichtenfolge dieselben Komponenten auf. Beispielsweise ist die zweite Elektrode und die organische Schichtenfolge sowohl in dem Hellbereich als auch in dem Dunkelbereich, im Rahmen der Herstellungstoleranzen, identisch gefertigt. Beispielsweise ist ebenso die erste Elektrode eine sich insbesondere durchgängig über den Dunkelbereich und den Hellbereich erstreckende Schicht mit einer bevorzugt, im Rahmen der Herstellungstoleranzen, konstanten Dicke. Das heißt, die Strukturierung der Strahlungsdurchtrittsfläche in Hellbereiche und Dunkelbereiche ist nicht durch eine Formgebung oder geometrische Ausgestaltung der ersten Elektrode, der zweiten Elektrode und der organischen Schichtenfolge erreicht.

Gemäß zumindest einer Ausbildung des organischen Bauteils weist dieses eine erste Reflektivität des Dunkelbereichs auf. Zum Beispiel ist die erste Reflektivität eine Reflektivität der Strahlungsdurchtrittsfläche in dem Dunkelbereich. Entsprechend weist das Bauteil eine zweite Reflektivität des Hellbereichs auf, die zum Beispiel eine Reflektivität der Strahlungsdurchtrittsfläche in dem Hellbereich ist.

Gemäß zumindest einer Ausbildung des organischen Bauteils weicht die erste Reflektivität des Dunkelbereichs von der zweiten Reflektivität des Hellbereichs um höchstens 15 Prozentpunkte, bevorzugt um höchstens 10 Prozentpunkte, insbesondere um höchstens 5 Prozentpunkte voneinander ab. Mit anderen Worten ist eine Reflektivität an der Strahlungsdurchtrittsfläche in dem Hellbereich und eine Reflektivität an der Strahlungsdurchtrittsfläche in dem Dunkelbereich näherungsweise gleich oder, bevorzugt, im Rahmen der Herstellungstoleranzen gleich.

Die Reflektivität ist zum Beispiel jeweils der Quotient aus einer einfallenden Strahlungsleistung und einer reflektierten, ausfallenden Strahlungsleistung. Zur Bestimmung der Reflektivität wird also beispielsweise die Lichtleistung, die auf die Strahlungsdurchtrittsfläche trifft, gemessen und mit einer von der Strahlungsdurchtrittsfläche reflektierten Lichtleistung verglichen. Beträgt zum Beispiel die erste Reflektivität des Dunkelbereichs 15 %, so liegt die zweite Reflektivität des Hellbereichs bevorzugt zwischen einschließlich 10 % und 20 %.

In mindestens einer Ausbildung des organischen optoelektronischen Bauteils umfasst dieses einen Träger sowie eine erste Elektrode, die am Träger angebracht ist. Weiterhin beinhaltet das Bauteil wenigstens eine organische Schichtenfolge mit zumindest einer organischen aktiven Schicht. Weiterhin weist das Bauteil eine zweite Elektrode auf, so dass sich die organische Schichtenfolge zwischen der ersten Elektrode und der zweiten Elektrode befindet. In einer lateralen Richtung sind mindestens ein Dunkelbereich und mindestens ein Hellbereich gebildet. Sowohl in dem Dunkelbereich als auch in dem Hellbereich ist stellenweise oder ganzflächig sowohl die erste Elektrode als auch die zweite Elektrode als auch die organische Schichtenfolge an dem Träger aufgebracht. Eine erste Reflektivität des Dunkelbereichs unterscheidet sich von einer zweiten Reflektivität des Hellbereichs um höchstens 15 Prozentpunkte.

Durch den mindestens einen Hellbereich und den mindestens einen Dunkelbereich kann ein Muster und/oder eine Beschriftung und/oder ein Symbol im Betrieb des Bauteils dargestellt werden. Die Hellbereiche bilden helle, leuchtende Bereiche etwa des Musters. Über die nicht oder schwächer leuchtenden Dunkelbereiche ist ein Kontrast zu den Hellbereichen gebildet. Dadurch, dass die erste Reflektivität des Dunkelbereichs und die zweite Reflektivität des Hellbereichs näherungsweise gleich sind, ist es möglich, dass etwa das Muster, das im Betrieb des Bauteils dargestellt wird, außerhalb des Betriebs des Bauteils nicht sichtbar ist. Mit anderen Worten kann, mit bloßem Auge von außen auf das Bauteil gesehen, insbesondere die Strahlungsdurchtrittsfläche des Bauteils homogen und unstrukturiert wirken, wenn das Bauteil nicht betrieben wird. Das heißt, außerhalb des Betriebs des Bauteils ist das Muster von einem Betrachter nicht erkennbar.

Gemäß zumindest einer Ausbildung des Bauteils ist in dem mindestens einen Dunkelbereich an einer dem Träger abgewandten Hauptfläche der ersten Elektrode eine Monoschicht mit selbstorganisierenden Molekülen aufgebracht. Die Monoschicht ist insbesondere nur in dem Dunkelbereich aufgebracht, sodass der Hellbereich frei ist von der Monoschicht. Bevorzugt ist der gesamte Dunkelbereich von der Monoschicht bedeckt. Mit anderen Worten können Dunkelbereiche ausschließlich dort sein, wo an der organischen Schichtenfolge, insbesondere in einer Richtung senkrecht zur Hauptfläche der ersten Elektrode, die Monoschicht erzeugt ist. Monoschicht bedeutet bevorzugt, dass eine Schichthöhe der Moleküle auf der Hauptseite nur genau ein Molekül beträgt. Es liegen in der Monoschicht demnach bevorzugt keine gleichen Moleküle übereinander.

Die Monoschicht befindet sich also zwischen der ersten Elektrode und der organischen Schichtenfolge. Die Monoschicht ist beispielsweise über ein Druckverfahren auf die erste Elektrode aufbringbar. Eine erzielbare Strukturgröße der Monoschicht, in einer lateralen Richtung, beträgt beispielsweise 100 µm, insbesondere 25 µm. Bevorzugt ist die Strukturgröße nur begrenzt durch eine Ortsauflösung eines zum Beispiel verwendeten Druckverfahrens beim Erzeugen der Monoschicht. Mit anderen Worten können sehr feine Muster der Monoschicht erzeugt sein.

Gemäß zumindest einer Ausbildung des organischen Bauteils ist die Monoschicht farblos gestaltet. Mit anderen Worten ist ein Absorptionskoeffizient und/oder ein Reflexionskoeffizient der Monoschicht im sichtbaren Spektralbereich näherungsweise nicht von der Wellenlänge abhängig. Beispielsweise ist der Absorptionskoeffizient und/oder der Reflexionskoeffizient im Spektralbereich zwischen 470 nm und 650 nm bis auf eine Abweichung von 10 Prozentpunkten, insbesondere bis auf eine Abweichung von 3 Prozentpunkten konstant. Zum Beispiel liegt der Absoptionskoeffizient zwischen einschließlich 0 % und 10 %, insbesondere zwischen einschließlich 0,01 % und 3 %.

Gemäß zumindest einer Ausbildung des organischen Bauteils ist die Monoschicht elektrisch isolierend. In einer Richtung senkrecht zur ersten Elektrode erfolgt also durch die Monoschicht im Betrieb des Bauteils kein Stromfluss hindurch. Weist die organische Schichtenfolge eine vernachlässigbare elektrische Querleitfähigkeit auf, so wird Strahlung in der organischen Schichtenfolge nur in solchen Bereichen erzeugt, in denen keine Monoschicht aufgebracht ist. Bevorzugt weist die Monoschicht eine Durchbruchspannung von mindestens 1 MV/cm auf, insbesondere von mindestens 30 MV/cm, in einer Richtung senkrecht zur ersten Elektrode.

Gemäß zumindest einer Ausbildung des organischen Bauteils liegt eine Dicke der Monoschicht, in einer Richtung senkrecht zur ersten Elektrode, zwischen einschließlich 0,5 nm und 5,0 nm, insbesondere zwischen einschließlich 1,0 nm und 3,0 nm. Die Monoschicht ist also im Vergleich zu einer Wellenlänge einer in der organischen Schichtenfolge erzeugten Strahlung sehr dünn. Daher wirkt sich die Monoschicht auf die optischen Eigenschaften des Bauteils, insbesondere auf den optischen Brechungsindex, nicht oder nur vernachlässigbar aus.

Gemäß zumindest einer Ausbildung des organischen Bauteils ist die Monoschicht mit Molekülen gebildet oder besteht aus solchen Molekülen, die lange aliphatische Ketten aufweisen und eine Phosphatgruppe, Silikatgruppe, Carbonylsäuregruppe, Trichlorsilangruppe oder eine ähnliche Gruppe als Kopfgruppe umfassen. Alternativ oder zusätzlich können die Moleküle der Monoschicht auch große Gruppen mit einem konjugierten Ringsystem, wie Benzol oder Cyclopentan, beinhalten. Beispiele für solche Moleküle sind 2[(trimethyloxysily)ethyl]benzene oder 3-[2-(trimethyloxysily) ethyl] pyridine.

Gemäß zumindest einer Ausbildung des organischen Bauteils weist der Träger an einer der Schichtenfolge zugewandten Seite in dem Dunkelbereich eine Aufrauung auf. Mit anderen Worten ist die der Schichtenfolge zugewandte Seite des Trägers in dem Hellbereich näherungsweise glatt und in dem Dunkelbereich gezielt rau. Die Aufrauung befindet sich also zwischen dem Träger und der ersten Elektrode.

Gemäß zumindest einer Ausbildung des organischen Bauteils weist die Strahlungsdurchtrittsfläche, im Rahmen der Herstellungstoleranzen, in dem Hellbereich als auch in dem Dunkelbereich eine gleiche Beschaffenheit auf, beispielsweise im Hinblick auf eine Rauheit. Mit anderen Worten ist insbesondere die der organischen Schichtenfolge abgewandte Seite des Trägers nicht strukturiert.

Gemäß zumindest einer Ausbildung des organischen Bauteils beträgt eine mittlere Rauheit der Aufrauung zwischen einschließlich 5 nm und 1 pm, insbesondere zwischen einschließlich 20 nm und 500 nm. Die Aufrauung weist also insbesondere eine mittlere Rauheit auf, die kleiner oder gleich einer Wellenlänge der in der organischen Schichtenfolge erzeugten Strahlung liegt.

Gemäß zumindest einer Ausbildung des organischen Bauteils weist die Aufrauung und/oder der Dunkelbereich eine laterale Strukturgröße von mindestens 1 mm, insbesondere von mindestens 3 mm, auf. Mit anderen Worten weist die Aufrauung, und somit bevorzugt auch der Dunkelbereich, in einer oder in zwei Richtungen eine Ausdehnung von mindestens den genannten Werten auf. Die Aufrauung kann also flächig ausgeformt sein.

Gemäß zumindest einer Ausbildung des organischen Bauteils ist die Aufrauung des Trägers in dem Dunkelbereich durch rillenartige oder kanalartige Strukturen gebildet, die eine der mittleren Rauheit entsprechende mittlere Tiefe aufweisen. Rillenartig kann bedeuten, dass eine mittlere Länge eine mittlere Breite der Strukturen mindestens um ein Zehnfaches übersteigt.

Gemäß zumindest einer Ausbildung des organischen Bauteils befindet sich zwischen dem Träger und der ersten Elektrode eine Zwischenschicht. Die Zwischenschicht weist bevorzugt einen Brechungsindex auf, der von dem des Trägers um höchstens 0,1, insbesondere um höchstens 0,05 abweicht. Beträgt der Brechungsindex des Trägers beispielsweise 1,50, so liegt der Brechungsindex der Zwischenschicht bevorzugt zwischen 1,45 und 1,55. Beispielsweise ist die Zwischenschicht eine Oxidschicht, insbesondere eine Siliziumdioxidschicht.

Gemäß zumindest einer Ausbildung des organischen Bauteils beträgt eine Dicke der Zwischenschicht, in einer Richtung senkrecht zur ersten Elektrode, zwischen einschließlich 10 nm und 200 nm, insbesondere zwischen einschließlich 15 nm und 40 nm. Ist die Zwischenschicht über der Aufrauung angebracht, so ist eine dem Träger abgewandte Seite der Zwischenschicht bevorzugt glatter als der Träger im Bereich der Aufrauung. Die mittlere Dicke der Zwischenschicht kann im Bereich der mittleren Rauheit der Aufrauung des Trägers liegen.

Gemäß zumindest einer Ausbildung des organischen Bauteils beträgt eine mittlere Strahlungsleistung pro Flächeneinheit des mindestens einen Dunkelbereichs höchstens 60 %, insbesondere höchstens 45 % der mittleren Strahlungsleistung pro Flächeneinheit des mindestens einen Hellbereichs. Beispielsweise wird in dem Dunkelbereich näherungsweise keine Strahlungsleistung emittiert. Ebenso ist es möglich, dass die Strahlungsleistung pro Flächeninhalt des Dunkelbereichs zwischen einschließlich 1 % und 60 % der des Hellbereichs beträgt, bevorzugt zwischen einschließlich 2 % und 45 %, insbesondere zwischen einschließlich 4 % und 30 %.

Gemäß zumindest einer Ausbildung des organischen Bauteils ist der Träger mit einem Glas, die erste Elektrode mit einem leitfähigen transparenten Oxid und die zweite Elektrode mit einem Metall gestaltet oder bestehen aus den genannten Werkstoffen. Die in der organischen Schichtenfolge erzeugte Strahlung durchläuft also den Träger und wird insbesondere an einer der organischen Schichtenfolge abgewandten Hauptseite des Trägers emittiert.

Gemäß zumindest einer Ausbildung des organischen Bauteils weist eine Hauptfläche der ersten Elektrode, die dem Träger abgewandt ist, in dem mindestens einen Dunkelbereich eine höhere Austrittsarbeit auf als in dem mindestens einen Hellbereich. Die Austrittsarbeit ist beispielsweise die minimale Energie, die benötigt wird, um einen Ladungsträger wie ein Elektron von einem Punkt innerhalb der ersten Elektrode an einen Punkt außerhalb der Oberfläche der ersten Elektrode zu befördern. Beispielsweise unterscheidet sich die Austrittsarbeit der ersten Elektrode in dem Dunkelbereich von der Austrittsarbeit in dem Hellbereich um mindestens 0,10 eV, bevorzugt um mindestens 0,25 eV, insbesondere um mindestens 0,40 eV. Ein Absolutwert der Austrittsarbeit liegt hierbei bevorzugt zwischen einschließlich 4,0 eV und 5,0 eV, insbesondere bei zirka 4,5 eV. Eine Modifizierung der Austrittsarbeit wird bevorzugt nicht dadurch erreicht, dass eine separate Beschichtung, zum Beispiel mit einer dünnen, insbesondere monolagigen Schicht organischer Moleküle, aufgebracht wird. Mit anderen Worten ist die erste Elektrode dann frei von einer solchen separaten, die Austrittsarbeit beeinflussenden Beschichtung.

Beispielsweise kann mittels des erfindungsgemäßen Verfahrens ein organisches optoelektronisches Bauteil hergestellt werden, wie es in Verbindung mit einer oder mehrerer der oben genannten Ausbildungen beschrieben ist. Merkmale des organischen optoelektronischen Bauteils sind daher auch für das hier beschriebene Verfahren offenbart und umgekehrt.

In mindestens einer Ausführungsform des Verfahrens umfasst dieses die folgenden Schritte:
- Bereitstellen eines Trägers mit einer ersten Elektrode,
- Aufbringen und, außerhalb einer Zone, Belichten eines lichtempfindlichen Materials an der ersten Elektrode,
- Entfernen des lichtempfindlichen Materials, wobei eine Dicke der ersten Elektrode im Rahmen der Herstellungstoleranzen unverändert bleibt,
- Aufbringen und, außerhalb eines Unterbereichs, Belichten eines weiteren lichtempfindlichen Materials an der ersten Elektrode,
- Entfernen des weiteren lichtempfindlichen Materials, und
- Erzeugen einer organischen Schichtenfolge mit zumindest einer organischen aktiven Schicht und einer zweiten Elektrode zumindest an der ersten Elektrode. Hierbei ist eine Austrittsarbeit an einer dem Träger abgewandten Hauptfläche der ersten Elektrode in mindestens einen Überlappbereich, in dem die Zone und der Unterbereich überlappen, im Vergleich zu übrigen Bereichen der ersten Elektrode herabgesetzt.

Mit anderen Worten wird in einem Verfahrensschritt etwa ein Fotolack auf der ersten Elektrode aufgebracht, und der Fotolack wird mindestens stellenweise belichtet. Anschließend wird der Fotolack beispielsweise nach einem Entwickeln entfernt, wobei die erste Elektrode nicht strukturiert wird. In einem anderen Schritt des Verfahrens wird ein weiteres lichtempfindliches Material, etwa ein Fotolack, auf der ersten Elektrode aufgebracht, belichtet und insbesondere auch entwickelt, und anschließend wiederum entfernt. Der mindestens eine Hellbereich ist dann durch einen solchen Bereich der ersten Elektrode gebildet, in dem zweifach lichtempfindliches Material aufgebracht und wieder entfernt wurde und der keiner Belichtung des lichtempfindlichen Materials ausgesetzt war. Derzeit wird angenommen, dass über das zweifache Auftragen, das zweifache Entfernen und bevorzugt auch das zweifache Entwickeln des lichtempfindlichen, unbelichteten Materials die Austrittsarbeit der ersten Elektrode herabsetzbar ist. Die herabgesetzte Austrittsarbeit führt wiederum dazu, dass der so behandelte Bereich im Betrieb des hergestellten Bauteils heller erscheint.

Gemäß zumindest einer Ausführungsform des Verfahrens ist die erste Elektrode mit Indiumzinnoxid gestaltet oder besteht aus Indiumzinnoxid. Weiterhin wird das lichtempfindliche Material und/oder das weitere lichtempfindliche Material über ein Veraschen mit einem O₂-Plasma und/oder über Spülen mit einem Lösungsmittel entfernt.

Gemäß zumindest einer Ausführungsform des Verfahrens wird zwischen dem Schritt des Belichtens des weiteren lichtempfindlichen Materials und dem Schritt des Entfernens des weiteren lichtempfindlichen Materials in einem zusätzlichen Verfahrensschritt außerhalb des Unterbereichs, in welchem das weitere lichtempfindliche Material nicht belichtet wurde, ein Material der ersten Elektrode vollständig oder teilweise entfernt. Mit anderen Worten wird die erste Elektrode über eine durch das weitere lichtempfindliche Material gebildete Maske strukturiert, wobei das Strukturieren durch Materialwegnahme der ersten Elektrode außerhalb des Unterbereichs, beispielsweise durch Wegätzen, erfolgt.

Gemäß zumindest einer Ausführungsform des Verfahrens wird durch den Überlappbereich, in dem der Unterbereich und die Zone überlappen, mindestens ein Hellbereich gebildet. Der Hellbereich stellt also zumindest einen Bereich der ersten Elektrode dar,
- in dem auf der ersten Elektrode zweifach ein lichtempfindliches Material aufgebracht wurde,
- der nicht belichtet wurde,
- in dem die lichtempfindlichen Materialien jeweils wieder entfernt wurden, und
- in dem bevorzugt die lichtempfindlichen Materialien jeweils auch entwickelt wurden.

Gemäß zumindest einer Ausführungsform des Verfahrens wird in einen verbleibenden, nicht zum Hellbereich gehörenden Bereich des Unterbereichs mindestens ein Dunkelbereich geformt. Der mindestens eine Hellbereich und der mindestens eine Dunkelbereich unterscheiden sich also nicht in einer Dicke oder Materialzusammensetzung der ersten Elektrode, sondern lediglich durch eine Austrittsarbeit an einer dem Träger abgewandten Hauptseite der ersten Elektrode.

Gemäß zumindest einer Ausführungsform des Verfahrens wird die erste Elektrode aus Indiumzinnoxid, kurz ITO, geformt oder besteht aus ITO. Das Belichten des lichtempfindlichen Materials und des weiteren lichtempfindlichen Materials erfolgt mit Wellenlängen zwischen einschließlich 240 nm und 380 nm. Als lichtempfindliches Material wird jeweils ein positiver Fotolack verwendet. Insbesondere in dem Hellbereich erfolgt ein Entwickeln sowohl des lichtempfindlichen Materials als auch des weiteren lichtempfindlichen Materials.

Gemäß zumindest einer Ausführungsform des Verfahrens werden die lichtempfindlichen Materialien vollständig entfernt. Mit anderen Worten ist das fertige, organische Bauteil dann frei von den lichtempfindlichen Materialien.

Einige Anwendungsbereiche, in denen hier beschriebene organische Bauteile Verwendung finden können, sind etwa die Hinterleuchtungen von Displays oder Anzeigeeinrichtungen. Weiterhin können hier beschriebene optoelektronische Bauteile in Beleuchtungseinrichtungen zu Projektionszwecken, in Scheinwerfern oder Lichtstrahlern oder bei der Allgemeinbeleuchtung eingesetzt werden.

Nachfolgend wird ein Bauteil sowie ein hier beschriebenes Verfahren unter Bezugnahme auf die Zeichnung anhand von Ausbildungen und Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figur 1: eine schematische Schnittdarstellung einer Ausbildung eines organischen optoelektronischen Bauteils,
- Figur 2: eine schematische Illustration einer Bestimmung einer Reflektivität von Hellbereichen und Dunkelbereichen,
- Figuren 3 und 4: schematische Schnittdarstellungen von weiteren Ausbildungen von organischen Bauteilen, und
- Figur 5: eine schematische Darstellung eines Ausführungsbeispiels eines hier beschriebenen Verfahrens zur Herstellung einer Ausbildung eines organischen optoelektronischen Bauteils.

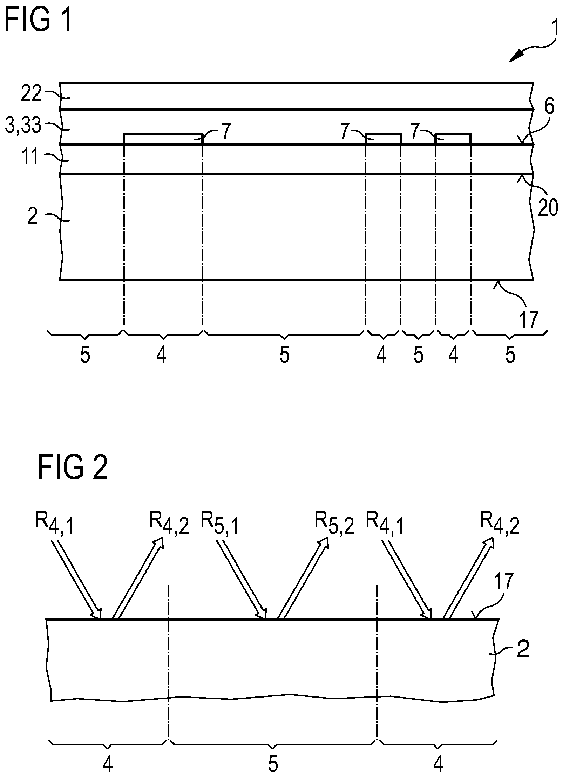

In Figur 1 ist eine Ausbildung eines organischen optoelektronischen Bauteils 1 zu sehen. An einer Hauptseite 20 eines Trägers 2 ist eine erste Elektrode 11 aufgebracht.

An einer dem Träger 2 abgewandten Hauptfläche 6 der ersten Elektrode 11 ist eine organische Schichtenfolge 3 mit einer organischen aktiven Schicht 33 aufgebracht. An einer dem Träger 2 abgewandten Seite der organischen Schichtenfolge 3 befindet sich eine zweite Elektrode 22. Im Betrieb des organischen optoelektronischen Bauteils 1 wird also die organische Schichtenfolge 3 über die erste Elektrode 11 und die zweite Elektrode 22 bestromt. In der organischen aktiven Schicht 33 wird im Betrieb des organischen optoelektronischen Bauteils 1 eine elektromagnetische Strahlung, bevorzugt im sichtbaren oder nahen ultravioletten Spektralbereich, generiert.

Der Träger 2 ist zum Beispiel mit Glas oder mit einer Glasfolie gestaltet. Die erste Elektrode 11 besteht zum Beispiel aus Indiumzinnoxid oder Indiumzinkoxid. Eine Dicke des Trägers 2, in einer Richtung senkrecht zur Hauptseite 20 des Trägers 2, beträgt beispielsweise zwischen einschließlich 200 µm und 2 mm. Eine Dicke der ersten Elektrode 11 beträgt zum Beispiel zwischen einschließlich 50 nm und 200 nm, insbesondere zirka 120 nm. Ein Brechungsindex eines Materials der ersten Elektrode 11 liegt insbesondere zwischen einschließlich 1,7 und 1,8. Ein Brechungsindex eines Materials des Trägers 2 beträgt zwischen etwa 1,45 und 1,55. Die organische Schichtenfolge 3 weist eine Dicke in der Größenordnung von 100 nm auf. Eine Dicke der zweiten Elektrode 22, die zum Beispiel durch ein aufgedampftes Metall oder durch eine Stahlfolie gebildet ist, liegt bevorzugt im Bereich von 20 nm bis 500 µm.

Auf der Hauptfläche 6 der ersten Elektrode 11 ist stellenweise eine Monoschicht 7 aufgetragen. Die Monoschicht 7 besteht aus selbstorganisierenden Molekülen. Beispielsweise ist die Monoschicht 7 mittels eines Druckverfahrens auf der Hauptfläche 6 aufgebracht. Eine Dicke der Monoschicht 7, in eine Richtung senkrecht zur Hauptfläche 6 der ersten Elektrode 11, beträgt insbesondere zwischen 0,5 nm und 5,0 nm. Die Dicke der Monoschicht 7 ist also bevorzugt um ein Vielfaches kleiner als die Dicke der organischen Schichtenfolge 3. Die Monoschicht 7 ist elektrisch isolierend und optisch transparent.

Da die organische Schichtenfolge 3 nur eine vernachlässigbare elektrische Querleitfähigkeit in einer Richtung parallel zur Hauptfläche 6 der ersten Elektrode 11 aufweist, erfolgt eine Bestromung der organischen aktiven Schicht 33 nur in solchen Bereichen, in denen keine Monoschicht 7 auf der ersten Elektrode 11 aufgebracht ist. Diese Bereiche, in denen die Monoschicht 7 aufgebracht ist, stellen also Dunkelbereiche 4 dar. Die Bereiche, in denen keine Monoschicht 7 aufgebracht ist, bilden Hellbereiche 5. Im Betrieb des organischen optoelektronischen Bauteils 1 erscheinen die Dunkelbereiche 4 also deutlich dunkler als die Hellbereiche 5. Näherungsweise wird in den Dunkelbereichen 4 in der organischen aktiven Schicht 33 keine elektromagnetische Strahlung im Betrieb des organischen optoelektronischen Bauteils 1 erzeugt.

Bei dem organischen optoelektronischen Bauteil 1 unterscheiden sich also die erste Elektrode 11, die organische Schichtenfolge 3 sowie die zweite Elektrode 22 bezüglich ihrer Ausgestaltung in den Dunkelbereichen 4 und in den Hellbereichen 5 nicht voneinander. Insbesondere dadurch, dass die erste Elektrode 11 im Wesentlichen die gesamte Hauptseite 20 des Trägers 2 bedeckt, ist außerhalb des Betriebs des organischen optoelektronischen Bauteils 1 ein durch die Monoschicht 7 gebildetes Muster der Hellbereiche 5 und der Dunkelbereiche 4 nicht erkennbar. Da die erste Elektrode 11 einen von dem Träger 2 deutlich unterschiedlichen Brechungsindex und somit ein unterschiedliches Reflexionsverhalten aufweist, wäre im Fall einer ersten Elektrode 11, die beispielsweise in den Dunkelbereichen 4 abgetragen wäre, das durch die Dunkelbereiche 4 und durch die Hellbereiche 5 gebildete Muster außerhalb des Betriebs des organischen optoelektronischen Bauteils 1 erkennbar.

Eine in der organischen aktiven Schicht 33 erzeugte Strahlung verlässt das organische optoelektronische Bauteil 1 durch den Träger 2 hindurch. Eine der ersten Elektrode 11 abgewandte Hauptseite des Trägers 2 bildet hierbei eine Strahlungsdurchtrittsfläche 17. Bevorzugt ist die zweite Elektrode 22 bezüglich der in der organischen Schichtenfolge 3 erzeugten Strahlung reflektierend und/oder strahlungsundurchlässig gestaltet.

Mit anderen Worten sind die Dunkelbereiche 4 und die Hellbereiche 5, außerhalb des Betriebs des organischen optoelektronischen Bauteils 1 und auf die Strahlungsdurchtrittsfläche 17 gesehen, nicht voneinander unterscheidbar. In dem Fall, dass die zweite Elektrode 22 lichtundurchlässig ist, bedeutet dies, dass sich eine erste Reflektivität der Dunkelbereiche 4 von einer zweiten Reflektivität der Hellbereiche 5 näherungsweise nicht unterscheidet.

Die erste und die zweite Reflektivität sind in Figur 2 näher erläutert. Die Reflektivitäten können ermittelt werden, indem eine Leistung einer auf die Strahlungsdurchtrittsfläche 17 gestrahlten Strahlung R_{4,1}, R_{5,1} und eine Strahlungsleistung einer an der Strahlungsdurchtrittsfläche 17 reflektierten Strahlung R_{4,2}, R_{5,2} in dem mindestens einen Dunkelbereich 4 und in dem mindestens einen Hellbereich 5 ermittelt und miteinander verglichen werden. Die erste Reflektivität der Dunkelbereiche 4 ist dann der Quotient aus den Strahlungsleistungen R_{4,2} und R_{4,1}. Entsprechend ist die zweite Reflektivität des Hellbereichs 5 der Quotient aus den Strahlungsleistungen R_{5,2} und R_{5,1}.

Beispielsweise weichen die erste und die zweite Reflektivität im sichtbaren Spektralbereich, also insbesondere zwischen 480 nm und 640 nm, sowie in einem Einfallswinkelbereich zwischen einschließlich 0° und 70° nicht oder näherungsweise nicht voneinander ab.

Für den Fall, dass das organische optoelektronische Bauteil 1 transparent oder strahlungsdurchlässig ist, können alternativ oder zusätzlich zur ersten Reflektivität und zur zweiten Reflektivität in analoger Weise Transmissionswerte des organischen optoelektronischen Bauteils 1 in den Dunkelbereichen 4 und in den Hellbereichen 5 bestimmt und miteinander verglichen werden. Bevorzugt unterscheiden sich dann die Transmissionswerte in den Dunkelbereichen 4 und in den Hellbereichen 5 sowie bevorzugt auch deren Reflektivitäten nicht oder näherungsweise nicht voneinander. Dass die Dunkelbereiche 4 und die Hellbereiche 5 außerhalb des Betriebs des organischen optoelektronischen Bauteils 1 von außerhalb des Bauteils nicht visuell unterscheidbar sind, liegt also zusammengefasst insbesondere daran, dass die erste Elektrode 11 sowohl die Dunkelbereiche 4 als auch die Hellbereiche 5 überspannt, und daran, dass die Monoschicht 7 die Reflektivität, eine Absorption und/oder die Transmission von Strahlung am oder durch das organische optoelektronische Bauteil 1 hindurch nicht oder nicht signifikant beeinflusst.

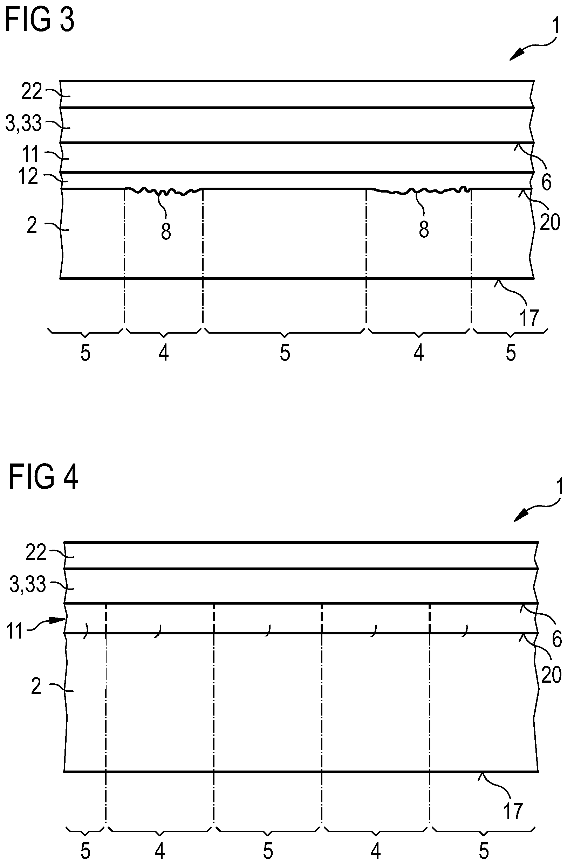

Eine weitere Ausbildung des organischen optoelektronischen Bauteils 1 ist in Figur 3 dargestellt. Zwischen der ersten Elektrode 11 und dem Träger 2 ist eine Zwischenschicht 12, bestehend aus beispielsweise Siliziumdioxid, angebracht. Eine Dicke der Zwischenschicht 12, in einer Richtung senkrecht zur Hauptfläche 6 der ersten Elektrode 11, beträgt zum Beispiel zirka 20 nm.

In den Dunkelbereichen 4 weist die Hauptseite 20 des Trägers 2 eine Aufrauung 8 auf. Die Aufrauung 8 ist von der Zwischenschicht 12 überdeckt. Eine dem Träger 2 abgewandte Hauptseite der Zwischenschicht 12 ist näherungsweise glatt. Mit anderen Worten kann die Zwischenschicht 12 die Aufrauung 8 des Trägers 2 vollständig oder zum Teil glätten.

Die erste Elektrode 11, die zweite Elektrode 22 sowie die organische Schichtenfolge 3 sind also über der Hauptseite 20 des Trägers 2 im Rahmen der Herstellungstoleranzen überall gleich aufgebracht. In lateraler Richtung wird in der gesamten organischen Schichtenfolge 3 eine Strahlung im Betrieb des organischen optoelektronischen Bauteils 1 erzeugt. Über die Aufrauung 8 erfolgt eine Lichtablenkung aus den Dunkelbereichen 4 weg in Richtung zu den Hellbereichen 5. Hierdurch ist eine mittlere Strahlungsleistung pro Fläche, die an der Strahlungsdurchtrittsfläche 17 das organische optoelektronische Bauteil 1 verlässt, in den Dunkelbereichen 4 um beispielsweise 50 % geringer als in den Hellbereichen 5. Durch die Aufrauung 8 ist eine Reflektivität der Strahlungsdurchtrittsfläche und der ersten Elektrode 11 näherungsweise nicht beeinflusst. Außerhalb des Betriebs des organischen optoelektronischen Bauteils 1 sind also die Dunkelbereiche 4 von den Hellbereichen 5, auf die Strahlungsdurchtrittsfläche 17 gesehen, nicht unterscheidbar.

Eine mittlere Rauheit der Aufrauung 8 liegt beispielsweise zwischen einschließlich 20 nm und 500 nm. Die Aufrauung ist etwa durch Laserbestrahlung der Hauptseite 20 des Trägers 2 oder durch Schleifen der Hauptseite 20 mit einem Schleifmittel mit einer definierten Körnung erzielbar. Die Aufrauung 8 kann bezüglich Haupterstreckungsrichtungen des Trägers 2 isotrop gestaltet sein oder auch zum Beispiel in Form von näherungsweise parallel laufenden Kanälen einer der Rauheit entsprechenden mittleren Tiefe realisiert sein.

Bei der Ausbildung gemäß Figur 4 ist die erste Elektrode 11 wiederum eine über die Hauptseite 20 des Trägers 2 durchgehende Schicht. Die Hauptfläche 6 der ersten Elektrode 11 weist allerdings in den Dunkelbereichen 4 eine höhere Austrittsarbeit auf als in den Hellbereichen 5. Somit werden in den Dunkelbereichen 4 weniger Ladungsträger in die organische Schichtenfolge injiziert als in den Hellbereichen 5. Dadurch erscheinen die Dunkelbereiche 4 dunkler, da im Betrieb des organischen optoelektronischen Bauteils 1 in den Dunkelbereichen 4 weniger Strahlung erzeugt wird. Außerhalb des Betriebs des organischen optoelektronischen Bauteils 1 sind die Dunkelbereiche 4 von den Hellbereichen 5, auf die Strahlungsdurchtrittsfläche 17 gesehen, nicht mit bloßem Auge unterscheidbar.

Die Austrittsarbeit an der Hauptfläche 6 der ersten Elektrode 11 in den Hellbereichen 5 sowie der ersten Elektrode 11 in den Dunkelbereichen 4 ist beispielsweise messbar, in dem die zweite Elektrode 22 und die aktive Schichtenfolge von der ersten Elektrode 11 entfernt werden, wobei die Hauptfläche 6 der ersten Elektrode 11 näherungsweise nicht verändert wird. Anschließend ist die Austrittsarbeit lokal etwa über Photoelektronenemissionsspektroskopie messbar.

Optional kann auch bei den Ausbildungen gemäß der Figuren 1 und 4 zwischen der ersten Elektrode 11 und dem Träger 2 eine Zwischenschicht 12, in den Figuren 1 und 4 nicht dargestellt, aufgebracht sein.

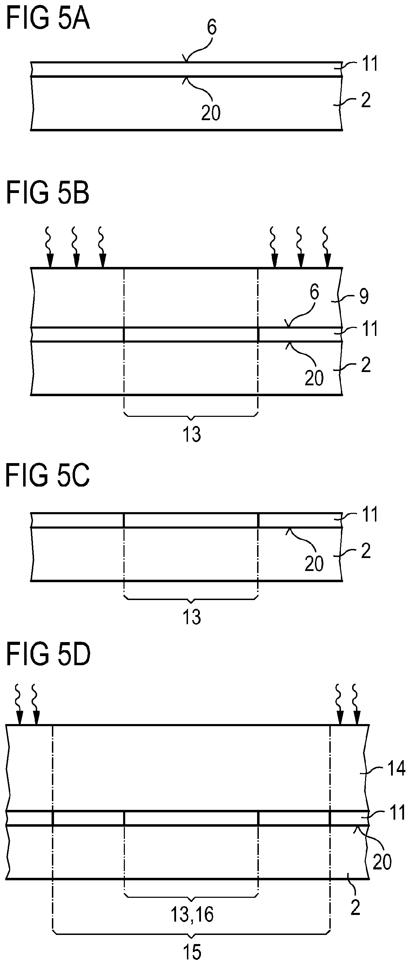

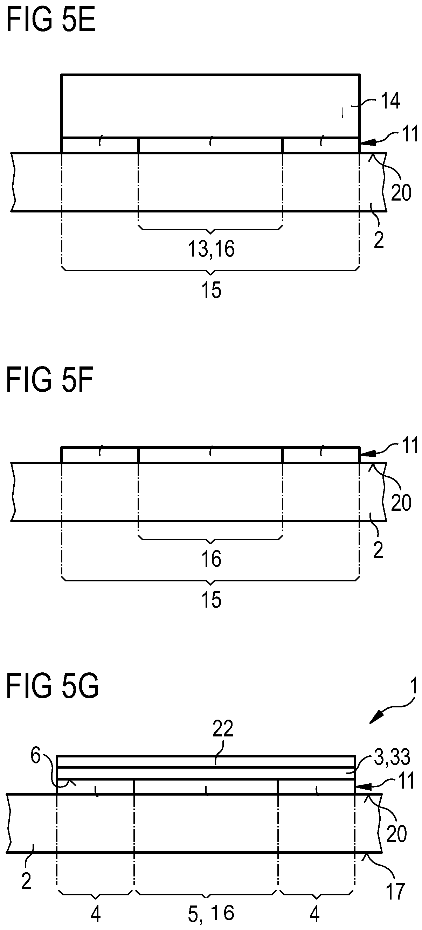

In Figur 5 ist ein Verfahren zur Herstellung eines organischen optoelektronischen Bauteils, zum Beispiel gemäß Figur 4, illustriert.

In einem Verfahrensschritt, siehe Figur 5A, wird auf der Hauptseite 20 des Trägers 2 die erste Elektrode 11 aufgebracht. Beispielsweise besteht die erste Elektrode 11 aus Indiumzinnoxid, kurz ITO.

In Figur 5B ist illustriert, dass auf einer Hauptfläche 6 der ersten Elektrode 11 ein lichtempfindliches Material 9 aufgebracht und insbesondere auch entwickelt wird. Eine Dicke des lichtempfindlichen Materials 9 beträgt zum Beispiel zirka 2 µm. Das lichtempfindliche Material 9 ist bevorzugt ein Positivfotolack, englisch positive resist. Das heißt, durch ein Belichten wird das lichtempfindliche Material 9 insbesondere nach dem Entwickeln mindestens zum Teil zerstört oder für bestimmte Lösungsmittel löslich gemacht.

Bei dem lichtempfindlichen Material handelt es sich beispielsweise um AZ 1518 oder OCG 825. Als Entwickler, englisch Developer, für das lichtempfindliche Material dient zum Beispiel MIF 350. Das Belichten erfolgt bevorzugt mit ungefilterter ultravioletter Strahlung einer Hg-Hochdrucklampe oder einer HgXe-Hochdrucklampe mit einer Strahlungsleistung von zirka 4 mW/cm² und einer Belichtungsdauer von zirka 20 s. Die Belichtung erfolgt nur außerhalb einer Zone 13 der ersten Elektrode 11. In Figur 5B ist die Belichtung durch Pfeile illustriert.

Wie in Figur 5C dargestellt, wird nachfolgend das lichtempfindliche Material 9 abgetragen. Beim Abtragen des lichtempfindlichen Materials 9 erfolgt keine oder keine signifikante Materialabtragung bezüglich der ersten Elektrode 11. Mit anderen Worten ist eine Dicke der ersten Elektrode 11, in einer Richtung senkrecht zur Hauptseite 20 des Trägers 2, von dem Abtragen des lichtempfindlichen Materials 9 nicht beeinflusst. Das Abtragen erfolgt bevorzugt durch Veraschung mit einem Sauerstoffplasma und durch Spülen mit einem Lösungsmittel, zum Beispiel einem Glykolester.

Weiterhin wird auf der ersten Elektrode 11, siehe Figur 5D, ein weiteres lichtempfindliches Material 14 aufgebracht und bevorzugt auch entwickelt. Auch bei dem weiteren lichtempfindlichen Material 14 kann es sich um einen Positivfotolack handeln. Außerhalb eines Unterbereichs 15 wird auch das weitere lichtempfindliche Material 14 belichtet, illustriert durch Pfeile.

Die Zone 13 der ersten Elektrode 11, außerhalb der bereits eine Belichtung des lichtempfindlichen Materials 9 erfolgte, ist von dem Unterbereich 15 vollständig oder teilweise umfangen. Der Bereich, in dem der Unterbereich 15 und die Zone 13 überlappen, stellt einen Überlappbereich 16 dar. In dem Überlappbereich 16 wurden also das lichtempfindliche Material 9 und das weitere lichtempfindliche Material 14 bevorzugt jeweils entwickelt, nicht jedoch belichtet. In einem weiteren Verfahrensschritt, siehe Figur 5E, wird das weitere lichtempfindliche Material außerhalb des Unterbereichs 15 entfernt. Weiterhin wird außerhalb des Unterbereichs 15 die erste Elektrode 11 abgetragen. Mit anderen Worten erfolgt eine Strukturierung der ersten Elektrode 11 durch eine Materialabtragung eines Materials der ersten Elektrode 11. Insbesondere wird zumindest stellenweise die Hauptseite 20 des Trägers 2 freigelegt.

Wie in Figur 5F illustriert, wird anschließend das weitere lichtempfindliche Material 14 abgetragen, ohne eine Dicke der ersten Elektrode 11 im Unterbereich 15 zu verändern.

Durch das bevorzugt zweimalige Entwickeln und das zweimalige Entfernen des lichtempfindlichen Materials 9 und des weiteren lichtempfindlichen Materials 14 ist an der Hauptfläche 6 der ersten Elektrode 11 in dem Überlappbereich 16 die Austrittsarbeit der ersten Elektrode 11 im Vergleich zur ersten Elektrode 11 außerhalb des Überlappbereichs 16 herabgesetzt.

Abschließend wird das organische optoelektronische Bauteil 1 fertig gestellt, siehe Figur 5G. Hierbei werden die organische Schichtenfolge 3 mit der mindestens einen organischen aktiven Schicht 33 sowie die zweite Elektrode 22 aufgebracht. Das Auftragen kann hierbei nur über der ersten Elektrode 11 oder, anders als in Figur 5G dargestellt, auch ganzflächig erfolgen.

Optional ist es möglich, dass weitere, in Figur 5G nicht dargestellte Schichten, beispielsweise zur Verkapselung des organischen optoelektronischen Bauteils 1 und insbesondere der organischen Schichtenfolge 3 aufgebracht werden. Weiterhin ist es optional möglich, dass an der Strahlungsdurchtrittsfläche 17 zum Beispiel eine Antireflexionsschicht aufgebracht wird.

## Patentansprüche

1. Verfahren zur Herstellung eines organischen optoelektronischen Bauteils (1) mit den Schritten:
- Bereitstellen eines Trägers (2) mit einer ersten Elektrode (11),
- Aufbringen und, außerhalb einer Zone (13), Belichten eines lichtempfindlichen Materials (9) an der ersten Elektrode (11),
- Entfernen des lichtempfindlichen Materials (9), wobei eine Dicke der ersten Elektrode (11) unverändert bleibt,
- Aufbringen und, außerhalb eines Unterbereichs (15), Belichten eines weiteren lichtempfindlichen Materials (14) an der ersten Elektrode (11),
- Entfernen des weiteren lichtempfindlichen Materials (14), und
- Erzeugen einer organischen Schichtenfolge (3) mit zumindest einer organischen aktiven Schicht (33) und einer zweiten Elektrode (22) zumindest an der ersten Elektrode (11),
wobei eine Austrittsarbeit an einer dem Träger (2) abgewandten Hauptfläche(6) der ersten Elektrode (11) in mindestens einem Überlappbereich (16), in dem die Zone (13) und der Unterbereich (15) überlappen, im Vergleich zu übrigen Bereichen der ersten Elektrode (11) herabgesetzt wird,
wobei zwischen dem Schritt des Belichtens und dem Schritt des Entfernens des weiteren lichtempfindlichen Materials (14) in einem weiteren Schritt außerhalb des Unterbereichs (15) ein Material der ersten Elektrode (11) entfernt wird,
und wobei durch den Überlappbereich (16) mindestens ein
Hellbereich (5) geformt wird,
und wobei durch einen verbleibenden, nicht zum Hellbereich (5) gehörenden Bereich des Unterbereichs (15) mindestens ein Dunkelbereich (4) geformt wird.

2. Verfahren nach dem vorhergehenden Anspruch,
wobei die erste Elektrode (11) mit oder aus Indiumzinnoxid geformt wird, das Belichten des lichtempfindlichen Materials (9) und des weiteren lichtempfindlichen Materials (14) mit Wellenlängen zwischen einschließlich 240 nm und 380 nm durchgeführt wird, und als lichtempfindliches Material (9) und als weiteres lichtempfindliches Material (14) ein positiver Fotolack verwendet wird und in dem Überlappbereich (16) beide lichtempfindlichen Materialien entwickelt werden.

## Claims

1. A method for producing an organic optoelectronic component (1) with the steps:
- provision of a carrier (2) with a first electrode (11),
- application of and, outside a zone (13), exposure of a light-sensitive material (9) on the first electrode (11),
- removal of the light-sensitive material (9), wherein a thickness of the first electrode (11) remains unchanged,
- application of and, outside a sub-region (15), exposure of another light-sensitive material (14) on the first electrode (11),
- removal of the other light-sensitive material (14), and
- production of an organic layer sequence (3) with at least one organic active layer (33) and a second electrode (22) at least on the first electrode (11),
wherein a work function on a major surface (6) of the first electrode (11) remote from the carrier (2) is reduced in at least one overlap region (16), in which the zone (13) and the sub-region (15) overlap, compared with other regions of the first electrode (11), wherein between the step of exposure and the step of removal of the other light-sensitive material (14), a material of the first electrode (11) is removed in a further step outside the sub-region (15),
and wherein due to the overlap region (16) at least one light region (5) is formed,
and wherein at least one dark region (4) is formed by a remaining area of the sub-region (15) not belonging to the light region (5).

2. The method according to the previous Claim, wherein the first electrode (11) is formed with or from indium tin oxide, the exposure of the light-sensitive material (9) and the other light-sensitive material (14) is carried out at wavelengths between 240 nm and 380 nm inclusively, and a positive photoresist is used as the light-sensitive material (9) and as the other light-sensitive material (14) and both light-sensitive materials are developed in the overlap region (16).

## Revendications

1. Procédé de fabrication d'un composant optoélectronique organique (1) avec les étapes de :
- mise à disposition d'un support (2) avec une première électrode (11),
- mise en place et, en dehors d'une zone (13), exposition d'un matériau photosensible (9) sur la première électrode (11),
- retrait du matériau photosensible (9), une épaisseur de la première électrode (11) demeurant inchangée,
- mise en place et, en dehors d'une sous-zone (15), exposition d'un matériau photosensible supplémentaire (14) sur la première électrode (11),
- retrait du matériau photosensible supplémentaire (14), et
- constitution d'une succession de couches organiques (3) avec au moins une couche active organique (33) et une deuxième électrode (22) au moins sur la première électrode (11),
dans lequel un travail de sortie est réduit sur une surface principale (6) de la première électrode (11) éloignée du support (2) dans au moins une zone de chevauchement (16), dans laquelle la zone (13) et la sous-zone (15) se chevauchent, par rapport aux autres zones de la première électrode (11),
dans lequel entre l'étape d'exposition et l'étape de retrait du matériau photosensible supplémentaire (14), un matériau de la première électrode (11) est retiré lors d'une étape supplémentaire en dehors de la sous-zone (15),
et dans lequel la zone de chevauchement (16) forme au moins une zone claire (5),
et dans lequel une zone résiduelle de la sous-zone (15) n'appartenant pas à la zone claire (5) forme au moins une zone foncée (4).

2. Procédé selon la revendication précédente, dans lequel la première électrode (11) est réalisée avec ou en oxyde d'indium-étain, l'exposition du matériau photosensible (9) et du matériau photosensible supplémentaire (14) s'effectue selon des longueurs d'ondes entre y compris 240 nm et 380 nm et une photorésine positive est utilisée comme matériau photosensible (9) et comme matériau photosensible supplémentaire (14) et les deux matériaux photosensibles sont développés dans la zone de chevauchement (16).
